# EUROPEAN PATENT APPLICATION

(11) **EP 4 611 028 A1**
(43) Date of publication of application: **03.09.2025**
(21) Application number: 24160701.9
(22) Date of filing: 29.02.2024
(51) Int. Cl.: H01L 21/673, H01L 21/677

(54) **CONTAINER, METHOD AND STOCKER FOR STORING AND/OR TRANSPORTING A SEMICONDUCTOR FABRICATION ARTICLE**

(71) Applicant: Brooks Automation (Germany) GmbH, 78256 Steißlingen (DE)
(72) Inventor: Schwetz, Michael, 8400 Winterthur (CH); Schmidt, Alexander, 8203 Schaffhausen (CH)
(74) Representative: Dehns Germany Partnerschaft mbB

(57) **Abstract**

The invention relates to a container (100) for storing and/or transporting a semiconductor fabrication article (190), particularly one or more of a wafer, a chip, a substrate and a photolithography mask, particularly an EUV reticle, the container (100) comprising an upper component (110) and a lower component (120), wherein the upper component (110) is reversibly attachable to the lower component (120), the container (100) further comprising a locking mechanism (140, 160), integrally formed within the upper component (110) and the lower component (120) and configured to restrict movement of the upper component (110) and the lower component (120) relative to one another, wherein the locking mechanism (140, 160) comprises a pin (112), which in a state in which the upper component (110) is attached to the lower component (120), extends from a first one of the upper (110) and lower (120) components into a second one of the upper (110) and lower (120) components, wherein the locking mechanism (140, 160) further comprises an engagement member (122, 162) accommodated within the second one of the upper (110) and lower (120) components, the engagement member (122, 162) being configured to selectively restrict movement of the pin (112) relative to the second one of the upper (110) and lower (120) components, wherein the pin (112) comprises a recess (114) and the engagement member (122, 162) is configured to engage with the recess (114). The invention further provides a method (200) for storing and/or transporting a semiconductor fabrication article (190) using such a container (100) and a stocker configured to perform such a method (200) and to hold a number of such containers (100).

## Description

The invention relates to devices methods and apparatuses for storing and/or transporting semiconductor fabrication articles.

### Background

Photolithography processes are widely used as one of the key steps in the manufacture of integrated circuits (ICs) and other semiconductor-related devices and/or structures. However, as the dimensions of features produced by such processes decrease, the importance of photolithography for the production of miniature ICs or other devices and/or structures rises.

In photolithography, a geometric pattern is transferred from a photomask (typically referred to as reticle) onto a substrate, for example a semiconductor wafer, by the use of light, a photosensitive layer and a subsequent etching step. Depending on the desired feature size on the substrate, the feature size of the reticle needs to be adapted as well as the wavelength of the light used for pattern transfer, with consideration of the Raleigh criterion.

In order to reduce the smallest achievable feature size, it has been proposed to use extreme ultraviolet (EUV) radiation. EUV radiation is electromagnetic radiation having a wavelength within the range of 5-20 nm, for example within the range of 5-10 nm.

Any contamination of the reticle may reduce the imaging performance of the photolithographic process and may in more serious cases require the reticle to be replaced. The reticle is typically expensive and therefore any reduction in the frequency with which it must be replaced is advantageous. Furthermore, replacement of the reticle is a time consuming process, during which the photolithographic process may have to be suspended, thereby reducing its efficiency, which is undesirable.

For EUV applications, particle contamination with particle sizes of less than 10 nm as well as chemical contamination, for example by adsorption of volatile organic compounds, can be relevant.

The reticles used for such EUV applications are therefore typically stored in a storage stocker, and retrieved when needed in connection with the lithography exposure equipment. Usually, the reticles are contained in a double shell container (dual pod) comprising a so-called EUV outer pod (EOP) and an EUV inner pod (EIP).

Such a dual pod is described in further detail in US 2019/0214287 A1, for example.

Since the acceptable level of particle contamination is extremely small, friction (which leads to abrasion and thus particle generation) of the reticle against the container as well as friction of container components relative to one another needs to be avoided. Therefore, typical EIPs are designed so as to accommodate one reticle in such a way that it has only very limited possibilities to move therein, for example by providing a respective accommodating cavity that essentially corresponds to the dimensions of the reticle to be stored therein. Typical EIPs are also equipped with additional reticle immobilizers to immobilize the reticle inside the EIP. In order to prevent contamination, the EIP is designed to enable a protective gas or vacuum to be applied to the reticle. To that end, typically orifices equipped with filter material are provided for the protective gas to enter from the EOP into the surroundings of the reticle contained in the respective EIP.

The EOP is equipped with one or more actuators adapted to bias the reticle immobilizer(s) of the EIP into a retaining position, thereby immobilizing the reticle inside the EIP when the EOP is attached to the EIP. The EOP also functions to immobilize the typically two pieces of the EIP against one another to prevent friction induced abrasion.

It is to be understood that the EIP components are moveable against one another as long as they are not immobilized from outside. In order to avoid friction induced abrasion caused by such movement, the EOP conventionally provides such immobilization functionality for the EIP while also providing protection against the surrounding atmosphere, which is necessary e.g. during transport between a storing position and process tools requiring reticles for operation.

EOPs are rather bulky, leading to high space requirements or "footprint" for stockers storing EUV reticles. Furthermore, they are made of polymeric material, which is also prone to abrasion and outgassing of volatile organic compounds.

### Summary

The present invention attempts to solve these problems by providing methods, devices and apparatuses with features according to the independent claims. Advantageous embodiments and additional features are provided in the dependent claims and discussed in the following description.

The present invention enables reducing the required space for storing reticles while ensuring at least the same level of contamination and damage protection provided by conventional systems. Chemical contamination during storage from outgassing EOPs is prevented and mechanical damage protection improved over storing reticles in dual pods. For example, EOPs can easily be damaged during an earthquake, while devices according to the present invention are less fragile, even under challenging conditions, as will be understood from the following description.

Aspects which can advantageously be considered when developing such an improved storage concept include that it is highly undesirable to change the way the reticles are provided to the photolithographic process equipment, this typically being the most complicated and costly part of a semiconductor production facility.

Therefore, since the photolithographic process equipment is typically adapted to receive dual pods, means for providing a conventional dual pod to the photolithographic process equipment are advantageously provided with the improved reticle stocker.

In a first aspect, the invention provides a container for storing and/or transporting a semiconductor fabrication article, particularly one or more of a wafer, a chip, a substrate and a photolithography mask, particularly an EUV reticle, the container comprising an upper component and a lower component, wherein the upper component is reversibly attachable to a top of the lower component, the container further comprising a locking mechanism, integrally formed within the upper component and the lower component and configured to restrict movement of the upper component and the lower component relative to one another. The locking mechanism comprises a pin, which in a state in which the upper component is attached to the lower component, extends from a first one of the upper and lower components into a second one of the upper and lower components. The locking mechanism further comprises an engagement member accommodated within the second one of the upper and lower components, the engagement member being configured to selectively restrict movement of the pin relative to the second component, wherein the pin comprises a recess and the engagement member is configured to engage with the recess. In the context of this invention, the term of "selectively restricting movement" is understood to mean that it can be selected between at least two options comprising a setting in which movement is restricted or prevented and a setting in which movement is not restricted, i.e. unhindered.

It is to be noted, that in the context of this specification, the term "container" is used for embodiments of this invention so as to avoid confusion with the term "pod" which is more commonly used in the art. Therefore, wherever in this specification, the term "container" is used to describe an embodiment of this invention, it can be replaced by the term "pod" without altering the meaning of the specification in any way.

By providing specific containers, especially for storage, the contamination level within a respective stocker may be greatly decreased in comparison to traditional storing methods in which the articles are stored within pods which are also used outside the stocker. The containers, during normal operation, do not have to leave the stocker and, therefore, cannot carry contaminants from outside the stocker into the stocker. It is, however, important to provide a comparable protection for the article during storage as is the case with the mentioned traditional storage conditions. The locking mechanism restricting movement of the container components relative to one another maintains the protective shell of the container around the article even in case of events as, for example, earthquakes or even simple power outages so that the article is not damaged in such situations.

In at least one embodiment, the engagement member is actuable from the outside of the container, such that the engagement member is toggled between an open position, in which the engagement is not engaged with the recess of the pin, and a locked position, in which the engagement member is engaged with the recess of the pin. This means that the locking functionality can selectively be effected or released as desirable in any given situation. For example, it may be necessary, e.g. in the event of an earthquake or a power outage, to manually recover reticles from a respective stocker. In such a situation, it may be desirable to keep the containers locked in order to protect the reticles as much as possible.

In at least one embodiment, the engagement member comprises a detent configured to provide a resisting force against moving the engagement member out of said open position and/or said locked position. This avoids an undesired self-opening of the locking mechanism.

In at least one embodiment, the container is configured to immobilise an article therein, when the upper component is attached to the lower component, particularly when the locking mechanism is in the locked position as defined herein before. This ensures a protection level which is comparable to the one provided by traditional dual pods, at least regarding mechanical damage to the stored or transported article.

In at least one embodiment, the engagement member comprises a plate shaped element being supported, rotatably about an axis perpendicular to a plane of maximum extension of the plate, in the second one of the upper and lower components. The plate element is anisotropic with respect to rotations about the axis of rotation. For example, the plate element may be provided in the form of a cylindrical disc with an indentation in its circumference for accepting the pin therein, the cylinder axis of the disc being oriented in a direction parallel to an axis of the pin, and the disc being supported rotatably, particularly about the cylinder axis. Other examples of such plate-shaped engagement members comprise eccentrically rotatable cylindrical discs (with or without indentations), triangular, square, pentagonal or any other regular or irregular polygonal plate elements. Independent of the specific form of the plate-shaped element, the rotational anisotropy enables the plate element to allow a tip of the pin to be moved past the plane of maximum extension of the plate, such that the recess of the pin comes to a rest within the plane of maximum extension of the plate. If in such a position, the plate element is rotated, the rotational anisotropy effects the plate element to engage with the recess such that movement of the pin along the pin's axis is substantially disabled.

Alternatively, the engagement member may comprise a cylindrical rod with an indentation in its circumference for accepting the pin therein, the cylinder axis of the rod being oriented in a direction perpendicular to a direction of the axis of the pin, and the rod being supported rotatably, particularly about the cylinder axis, in the second one of the upper and lower components.

Independently of the specific shape of the engagement member, in at least one embodiment, a radial depth of the indentation (or any other form of radially recessed portion of a rotationally anisotropic engagement member) for accepting the pin corresponds to a depth of the recess of the pin. The radial depth may be defined as a difference between a maximum distance and a minimum distance from the axis of rotation of the engagement member to its circumference.

Such embodiments of engagement members are comparatively easy to provide and operate. A rotation about the cylinder axis may, for example, be realised using a tool like a screw driver or a similar device, thereby rotating the indentation into a position in which the pin may pass through the indentation and/or in a position in which the unindented circumference of the engagement member protrudes into the recess of the pin, thereby hindering the pin from being retracted from the second one of the upper and lower components.

In at least one embodiment, a cavity within the second one of the upper and lower components, in which the engagement member is supported, is accessible from the outside of the container. This allows for inspection and/or maintenance of the engagement member, which may be necessary for assessing a health state of the engagement member, particularly regarding abrasion and/or particle generation due to friction.

In at least one embodiment, said cavity is sealingly covered by a removable cover. This prevents particles generated, for example, by operating (i.e. actuating) the engagement member from leaving the cavity and contaminating a surrounding of the container, e.g. the inside of a respective reticle stocker.

In at least one embodiment, said cover is transparent with respect to at least one portion of the wavelength spectrum comprising visible light and/or UV-light and/or X-ray-radiation. This allows for visual or any other radiation-based inspection, without the need of removing the cover.

A second aspect of the invention provides a method of storing and/or transporting a semiconductor fabrication article comprising enclosing the article in a container as described herein, and storing the container within a storage position within a semiconductor fabrication stocker, particularly a reticle stocker.

In at least one embodiment, the method further comprises receiving an EUV dual pod comprising an EUV inner pod and an EUV outer pod and containing the article, opening the outer pod and the inner pod, recovering the article from the inner pod and arranging the container around the article retrieved from the inner pod.

In at least one embodiment, the method comprises actuating the engagement member into an unengaged (or open) position, opening the container, placing the article into the container, closing the container and actuating the engagement member into an engaged (or locked) position.

In at least one embodiment, the method further comprises providing an EUV dual pod, wherein providing an EUV dual pod comprises retrieving a container as described herein from a respective storage position within the stocker, actuating the engagement member into the unengaged (or open) position and arranging an outer pod around the container. Providing the dual pod in this manner may also be realised without the steps of storing the container. In other words, the container may be used as a replacement of a traditional inner pod. To this end, the locking mechanism should be in the open position, such that equipment apart from storage systems do not need any modification for handling such a dual pod provided by this method. For example, the container with the locking mechanism in the open position may be handled by a photolithography device as if it were a traditional inner pod. For such embodiments, the container may be provided with interaction interface for an outer pod to provide the immobilising functionality. Typically, an outer pod interacts with an inner pod by pressing the upper and lower components of the inner pod against one another. To this end, actuators are provided in the outer pod. For the container according to such embodiments of this invention to be used as a replacement for an inner pod, the interaction interface may be pressure points at predefined positions of the upper and or lower component for the actuators to apply a predefined pressing force to the container. When such a dual pod is received by a stocker, the outer pod may be opened, the container locked by virtue of actuating the engagement member into the locked position, and the container may then be stored within a respective storage position without removing it from the

container acting as an inner pod. This provides the advantage that fewer handling operations with the reticle (or other article) being exposed are required.

In a further aspect, the invention provides a stocker for storing a semiconductor fabrication article, particularly one or more of a wafer, a chip, a substrate, and a photolithography mask, particularly an EUV reticle, configured to perform a method as described herein and to hold a number of containers as described herein within storage positions in the stocker. The stocker, therefore, correspondingly profits from the same advantages as the respective embodiments of the method and/or the container.

### Brief description of the drawings

Figure 1 schematically depicts an embodiment of a container according to the invention in a perspective view.
Figure 2 schematically depicts a detail of the embodiment of Figure 1 during use in a partial perspective view.
Figure 3 schematically depicts a detail of the embodiment of Figure 1 during use in a partial sectional perspective view.
Figure 4 schematically depicts a detail of the embodiment of Figure 1 during use in a partial sectional top view.
Figure 5 schematically depicts a detail of the embodiment of Figure 1 in a partial bottom view.
Figure 6 schematically depicts the operation of a locking mechanism of an embodiment of a container according to the invention in a side plan view.
Figure 7 schematically depicts another embodiment of a container according to the invention in a bottom view.
Figure 8 schematically depicts a detail of the embodiment of Figure 7 in a partial bottom view.
Figure 9 schematically depicts a detail of the embodiment of Figure 7 in a partial perspective view.

In the description of the drawings, like elements are referred to with identical reference numerals. Their respective description is not repeated for every figure for reasons of conciseness.

### Embodiment(s) of the invention

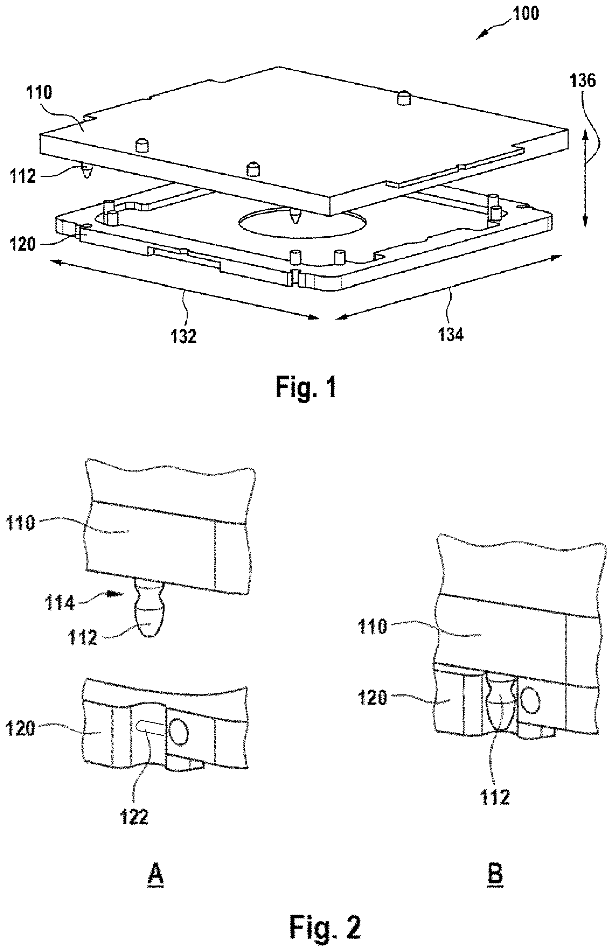

In Figure 1, an embodiment of a container according to the invention is schematically depicted in a perspective view and collectively referred to by reference numeral 100.

The container 100 comprises an upper component 110 and a lower component 120. During typical use of container 100, the geodesic references "upper" and "lower" have their common meaning, i.e. the upper component 110 is typically further away from the ground than the lower component 120.

The upper component 110 is attachable to the lower component 120, for example by relative movement towards the lower component 120 in a vertical direction 136 and comprises at least one pin 112 (in the example shown here, four such pins 112 are provided) for proper alignment of the upper 110 and lower 120 components relative to one another. To this end, the pin 112 extends into the lower component 120, when the two components 110, 120 are attached to one another. This pin 112 then restricts movement of the upper 110 and lower 120 components relative to one another in lateral (horizontal) directions 132, 134.

In Figure 2 a detail of the embodiment of Figure 1 is schematically depicted in a partial perspective view. Specifically, it is illustrated, how the attachment of the upper component 110 to the lower component 120 is realised and how the pin 112 aids in aligning the upper 110 and lower 120 components relative to one another. In view A of Fig. 2, the two components are detached from one another, such that the container 100 is open, i.e. an inner volume of the container 100 is accessible from the outside in this state. In view B of Fig. 2, the two components 110, 120 are attached to one another such that the container 100 is closed, i.e. the inner volume of container 100 is inaccessible in this state. Furthermore, it can be seen that the pin 112 comprises a recess 114 which is engageable by an engagement member 122 provided in the form of a cylindrical rod in the lower component 120. The engagement member 122 and the pin 112 are parts of a locking mechanism, that is denoted 140 in the subsequent figures.

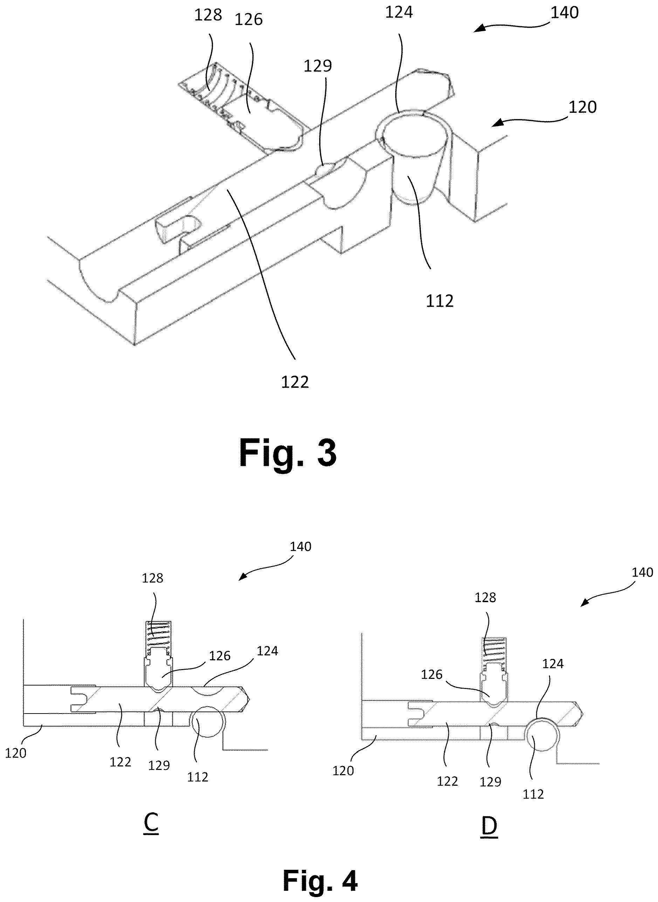

In Figures 3 and 4, a detail of the embodiment of Figure 1 in use is schematically depicted in a partial sectional perspective view and partial sectional top views, respectively. Particularly, these figures illustrate the locking mechanism 140 in greater detail. As shown, the locking mechanism comprises the pin 112 of the upper component 110 and the cylindrical rod 122 in the lower component 120. This cylindrical rod 122 comprises an indentation 124 in an axial position with respect to the cylindrical rod 122, into which the pin 112 extends when the upper component 110 is attached to the lower component 120. The indentation 124 has a depth in the cylindrical rod 122 that substantially corresponds to the depth of the recess 114 in the pin 112. The cylindrical axis of the rod 122 is substantially orthogonal to an axis of the pin 112, i.e. orthogonal to the vertical direction 136 already mentioned in connection with Fig. 1. The cylindrical rod 122 is supported in the lower component 120 rotatably about its axis, such that the indentation may be rotated away from the location into which the pin 112 extends. This is best seen by comparison of Figs. 4C and 4D, where Fig. 4D depicts a situation, in which the indentation 124 in the rod 122 faces the pin 112 ("unlocked position") and Fig. 4C depicts a situation, in which the indentation 124 in the rod 122 does not face the pin 112 ("locked position"). In the locked position, the rod 122 is engaged with the recess 114, i.e. extends into the recess 114, such that in the locked position, the pin 112 is restricted in movement relative to the lower component 120 by virtue of the engagement member or rod 122, particularly in the vertical direction 136.

As can be seen from the figures, particularly Figs. 3 and 4, the rod is actuable from the outside of the container such that the locking mechanism 140 may be toggled between the locked and the unlocked position as required, for example using a tool that may have an end shape similar to a screwdriver.

In Fig. 4, a detent is shown that is configured to provide a resisting force against removing the engagement member, i.e. the rod 122, in the depicted example, from the locked and unlocked positions. In the example shown, the detent comprises a conical tip 126 that is biased towards the rod 122 by a spring 128. Along the circumference of the rod 122 in the axial position in which the tip 126 abuts against the rod, a dimple 129 is formed in each of the circumferential positions facing the tip 126 in the locked and unlocked positions, respectively. This results in the tip 126 protruding into the dimple in these positions such that the biasing force of the spring needs to be overcome in order to remove the rod from the locked or unlocked position, such that the rod cannot inadvertently be removed from these positions, for example as a result of vibrations or the like. This ensures proper alignment of the rod 122 for any handling operations relating to the container 100, particularly for opening and closing the container 100.

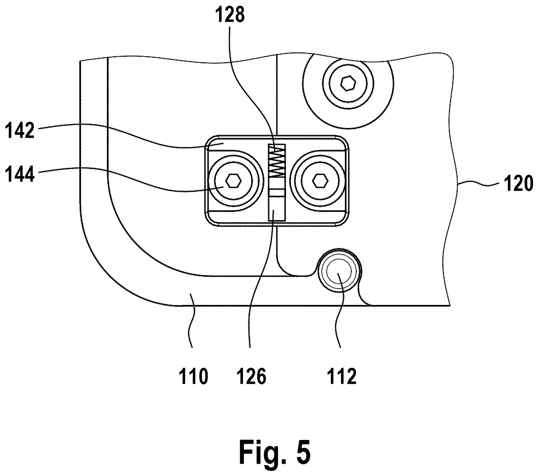

The whole part of the locking mechanism 140 provided in the bottom component 120 is accommodated in a cavity within the bottom component 120. This cavity is accessible from outside the container 100 as can be seen in Fig. 5. The cavity is not directly connected with an inside of the container 100, i.e. it is closed towards the top of the bottom component 120.

In Figure 5 a detail of the embodiment of Figure 1 is schematically depicted in a partial bottom view.

The cavity in the bottom component 120 mentioned above is covered by a cover 142 that seals this cavity towards the outside of the container 100. Particularly, the cover is configured to withhold at least 90%, 95%, 98%, 99%, 99.5%, 99.9 or more than 99.99% of particles with a diameter greater than 40 nm, particularly relating to total particle mass and/or number within the cavity.

In the embodiment shown, the cover 142 seals a part of the cavity, in which the tip 126 and spring 128 are provided, and is transparent at least in the spectral range of visible light, which allows for visual inspection of the tip 126 and the spring 128, which is particularly prone to abrasion and damage in general. The cover 142, in the example shown here, is reversibly removable from the bottom component 120 and is fixed to the bottom component 120, e.g. with screws or threaded bolts 144. This allows for accessing the detent 126, 128 separately, i.e. without the need for dismantling the complete locking mechanism, e.g. for maintenance and/or replacement.

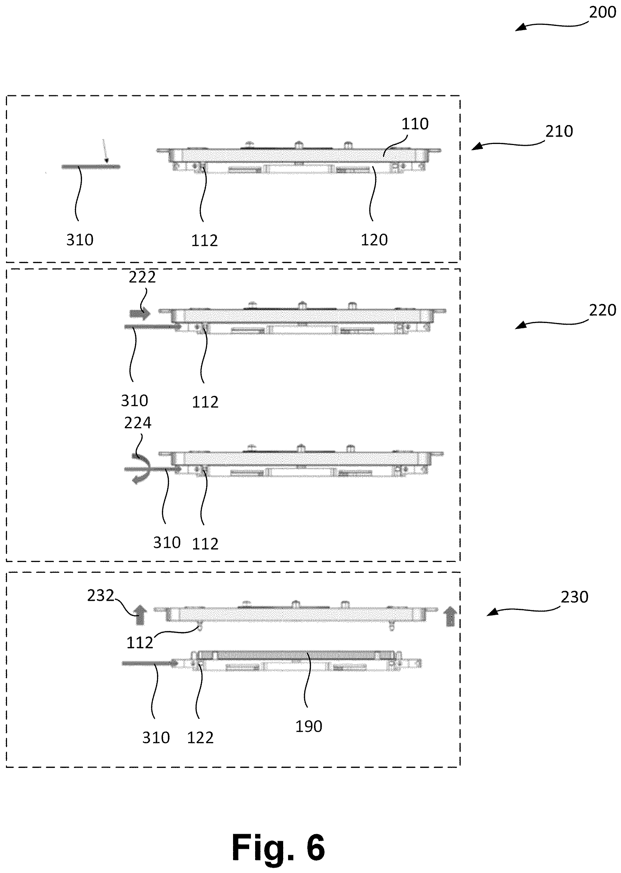

In Figure 6 the operation of a locking mechanism of an embodiment of a container according to the invention is schematically depicted in a side plan view. This can be interpreted as an illustration of an embodiment of a method according to the invention, which is collectively referred to by reference numeral 200.

In a first step 210 of the method 200, a container 100 (particularly a container 100, in which the locking mechanism is in the locked position) is positioned such that the locking mechanism 140, particularly the engagement member (in the depicted case, the cylindrical rod 122), is accessible for a tool 310 from outside the container.

In a step 220, the tool 310 is engaged with the engagement member 122 (indicated by relative movement arrow 222) and the engagement member 122 is actuated into the unlocked position, e.g. by rotating the engagement member by a predefined angular amount, for example by 90°, about its cylindrical axis (indicated by rotational movement arrow 224).

In a step 230, the container 100 is opened, i.e. the upper component 110 is lifted off the lower component 120 (indicated by vertical movement arrow 232) in the vertical direction 136, such that the inner volume of the container 100 is accessible, and an article 190 contained therein may be handled.

The illustrated steps may be performed in reverse order and direction in order to enclose the article 190 in the container 100 and to lock the container 100.

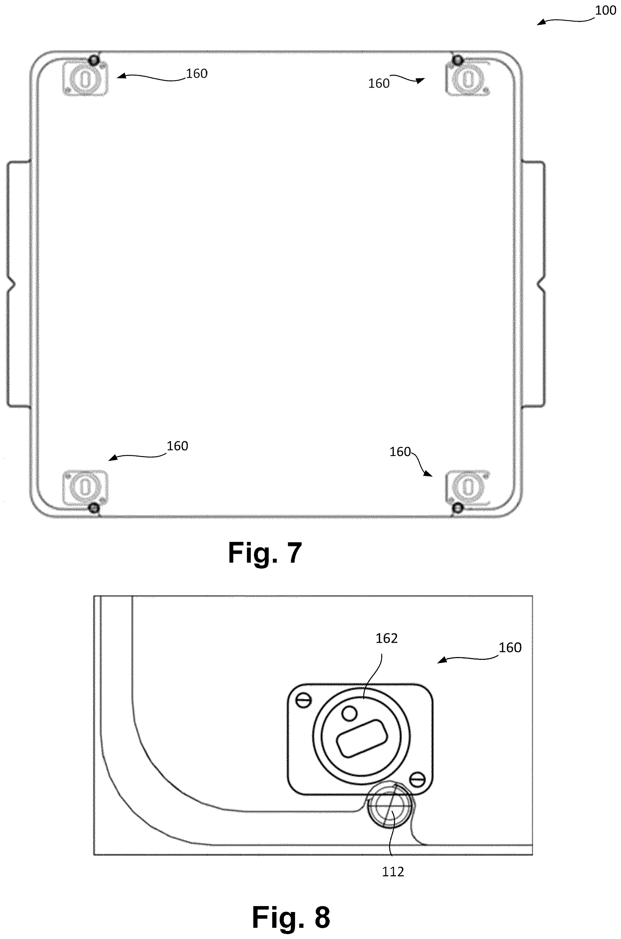

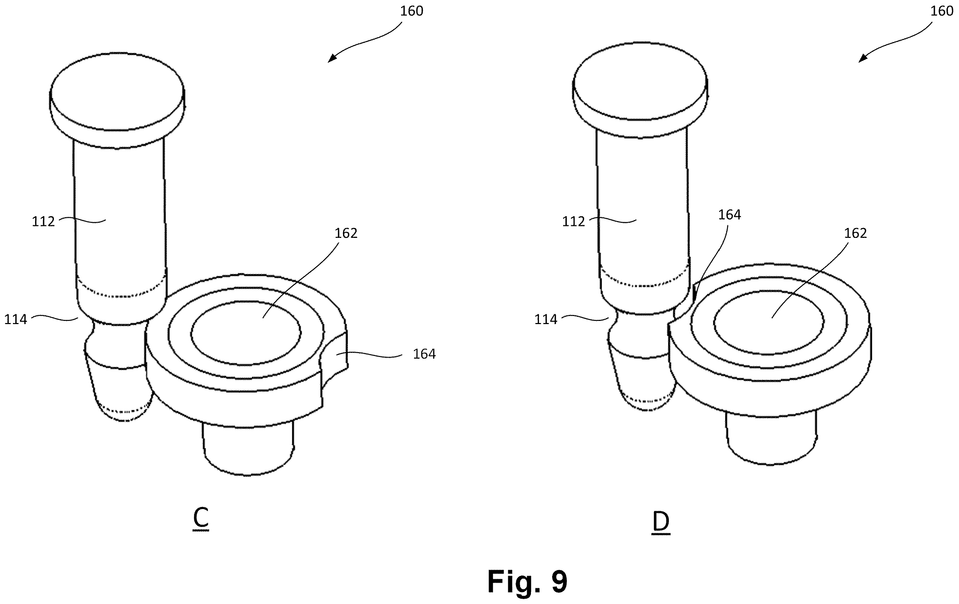

In Figure 7, another embodiment of a container 100 according to the invention is schematically depicted in a bottom view. The container 100 shown here differs from the embodiment of Figure 2 to 5 in the specific configuration of the locking mechanism, which here is collectively referred to by reference numeral 160. This locking mechanism 160 is shown in greater detail in Figures 8 and 9 in a partial bottom view and a partial perspective view, respectively.

The locking mechanism 160 comprises the pin 112 and a substantially circular disc 162, which functionally replaces the circular rod 122 of the embodiment previously discussed with reference to Figures 2 to 6. The circular disc 162 comprises an indentation 164 in its circumference. This indentation is configured for accepting the pin 112 therein, when the upper component 110 of the container 100 is attached to the lower component. The disc 162 is supported in the lower component 120 to be rotatable about the cylindrical axis of the disc. In the case of locking mechanism 160, this cylindrical axis of the disc 162 is oriented substantially in parallel to the axis of the pin 112, i.e. in the vertical direction 136. The disc may be toggled between a locked state C (as best seen in Figure 9) and an unlocked or open state D by rotating the indentation 164 towards or away from the position into which the pin 112 extends, thereby causing the disc 162 to engage or disengage with the recess 114 of the pin 112. This is substantially the same kind of interaction as already discussed with reference to the cylindrical rod 122, except that the axis of rotation in the case of the disc-shaped engagement member 162 is vertical instead of horizontal. Therefore, an actuation of the disc 162 is effected from a bottom side of the container 100 instead of a lateral side. This provides the advantage that a tool for actuating the disc 162 may be integrated into a support on which opening and closing of the container is typically performed. Thus, in comparison with the embodiment with the cylindrical rod 122 as the engagement member of the locking mechanism 140, fewer movements are required for the actuation of the engagement member 162. Specifically, only a rotation is required, since in such a case, the tool is automatically inserted upon placement of the container on the support. Furthermore, since the actuation is effected from a bottom of the container, any particles generated by abrasion in the process of actuating will fall downwards, i.e. away from container 100, thereby improving the contamination behaviour of the locking mechanism 160 in comparison to other options of restricting movement of the upper 110 and lower 120 components of container 100.

## Claims

1. Container (100) for storing and/or transporting a semiconductor fabrication article (190), particularly one or more of a wafer, a chip, a substrate and a photolithography mask, particularly an EUV reticle,
the container (100) comprising an upper component (110) and a lower component (120),
wherein the upper component (110) is reversibly attachable to the lower component (120),
the container (100) further comprising a locking mechanism (140, 160), integrally formed within the upper component (110) and the lower component (120) and configured to restrict movement of the upper component (110) and the lower component (120) relative to one another,
wherein the locking mechanism (140, 160) comprises a pin (112), which in a state in which the upper component (110) is attached to the lower component (120), extends from a first one of the upper (110) and lower (120) components into a second one of the upper (110) and lower (120) components,
wherein the locking mechanism (140, 160) further comprises an engagement member (122, 162) accommodated within the second one of the upper (110) and lower (120) components,
the engagement member (122, 162) being configured to selectively restrict movement of the pin (112) relative to the second one of the upper (110) and lower (120) components,
wherein the pin (112) comprises a recess (114) and the engagement member (122, 162) is configured to engage with the recess (114).

2. Container (100) according to claim 1, wherein the engagement member (122, 162) is actuable from the outside of the container (100), such that the engagement member (122, 162) is toggled between an open position (D), in which the engagement member (122, 162) is not engaged with the recess (114) of the pin (112), and a locked position (C), in which the engagement member (122, 162) is engaged with the recess (114) of the pin (112).

3. Container (100) according to claim 2, wherein the engagement member (122, 162) comprises a detent (126, 128) configured to provide a resisting force against removing the engagement member (122, 162) from the open position (D) and/or the locked position (C).

4. Container (100) according to any of the preceding claims, configured to immobilise an article (190) therein, when the upper component (110) is attached to the lower component (120), particularly when the locking mechanism (140, 160) is in the locked position (C) as defined in claim 2.

5. Container (100) according to any of the preceding claims, wherein the engagement member (122, 162) comprises a cylindrical disc (162) with an indentation (164) in its circumference for accepting the pin (112) therein,
the cylinder axis of the disc (162) being oriented in a direction (136) parallel to an axis of the pin (112), and
the disc (162) being rotatably supported in the second one of the upper (110) and lower (120) components.

6. Container (100) according to any of claims 1 to 4, wherein the engagement member (122, 162) comprises a cylindrical rod with an indentation (124) in its circumference for accepting the pin (112) therein,
the cylinder axis of the rod being oriented in a direction (134) perpendicular to a direction (136) of an axis of the pin (112), and
the rod being rotatably supported in the second one of the upper (110) and lower (120) components.

7. Container (100) according to claim 5 or 6, wherein a depth of the indentation (124, 164) for accepting the pin (112) corresponds to a depth of the recess (114) of the pin (112).

8. Container (100) according to any of the preceding claims, wherein a cavity within the second one of the upper (110) and lower (120) components, in which the engagement member (122, 162) is supported, is accessible from the outside of the container (100).

9. Container (100) according to claim 8, wherein the cavity is sealingly covered by a removable cover (142).

10. Container (100) according to claim 9, wherein the cover (142) is transparent with respect to at least one portion of the wavelength spectrum comprising visible light and/or UV-light and/or X-ray-radiation.

11. Method (200) for storing and/or transporting a semiconductor fabrication article (190) comprising enclosing the article (190) in a container (100) according to any one of the preceding claims, and storing the container (100) within a storage position within a semiconductor fabrication stocker, particularly a reticle stocker.

12. Method (200) according to claim 11, further comprising receiving an EUV dual pod comprising an EUV inner pod and an EUV outer pod and containing the article (190), opening the outer pod and the inner pod, recovering the article (190) from the inner pod and arranging the container (100) around the article (190) retrieved from the inner pod.

13. Method (200) according to claim 11 or 12 comprising actuating (224) the engagement member (122, 162) into an unengaged position (D), opening (232) the container (100), placing the article (190) into the container, closing the container (100) and actuating (224) the engagement member (122, 162) into an engaged position (C).

14. Method (200) according to any one of claims 11 to 13, further comprising providing an EUV dual pod, wherein providing an EUV dual pod comprises
retrieving a container (100) according to any one of claims 1 to 10 from a respective storage position within the stocker,
actuating (224) the engagement member (122, 162) into the unengaged position (D) and
arranging an outer pod around the container (100).

15. Stocker for storing a semiconductor fabrication article (190), particularly one or more of a wafer, a chip, a substrate and a photolithography mask, particularly an EUV reticle, configured to perform a method (200) according to any one of claims 11 to 14 and to hold a number of containers (100) according to any one of claims 1 to 10 within storage positions in the stocker.

## Amended claims

### Amended claims in accordance with Rule 137(2) EPC.

1. Container (100) for storing and/or transporting a semiconductor fabrication article (190), particularly one or more of a wafer, a chip, a substrate and a photolithography mask, particularly an EUV reticle,
the container (100) comprising an upper component (110) and a lower component (120),
wherein the upper component (110) is reversibly attachable to the lower component (120),
the container (100) further comprising a locking mechanism (140, 160), integrally formed within the upper component (110) and the lower component (120) and configured to restrict movement of the upper component (110) and the lower component (120) relative to one another,
wherein the locking mechanism (140, 160) comprises a pin (112), which in a state in which the upper component (110) is attached to the lower component (120), extends from a first one of the upper (110) and lower (120) components into a second one of the upper (110) and lower (120) components,
wherein the locking mechanism (140, 160) further comprises an engagement member (122, 162) accommodated within the second one of the upper (110) and lower (120) components,
the engagement member (122, 162) being configured to selectively restrict movement of the pin (112) relative to the second one of the upper (110) and lower (120) components,
wherein the pin (112) comprises a recess (114) and the engagement member (122, 162) is configured to engage with the recess (114),
**characterised in that** the engagement member (122, 162) is actuable from the outside of the container (100), such that the engagement member (122, 162) is toggled between an open position (D), in which the engagement member (122, 162) is not engaged with the recess (114) of the pin (112), and a locked position (C), in which the engagement member (122, 162) is engaged with the recess (114) of the pin (112).

2. Container (100) according to claim 1, wherein the engagement member (122, 162) comprises a detent (126, 128) configured to provide a resisting force against removing the engagement member (122, 162) from the open position (D) and/or the locked position (C).

3. Container (100) according to any of the preceding claims, configured to immobilise an article (190) therein, when the upper component (110) is attached to the lower component (120), particularly when the locking mechanism (140, 160) is in the locked position (C) as defined in claim 2.

4. Container (100) according to any of the preceding claims, wherein the engagement member (122, 162) comprises a cylindrical disc (162) with an indentation (164) in its circumference for accepting the pin (112) therein,
the cylinder axis of the disc (162) being oriented in a direction (136) parallel to an axis of the pin (112), and
the disc (162) being rotatably supported in the second one of the upper (110) and lower (120) components.

5. Container (100) according to any of claims 1 to 3, wherein the engagement member (122, 162) comprises a cylindrical rod with an indentation (124) in its circumference for accepting the pin (112) therein,
the cylinder axis of the rod being oriented in a direction (134) perpendicular to a direction (136) of an axis of the pin (112), and
the rod being rotatably supported in the second one of the upper (110) and lower (120) components.

6. Container (100) according to claim 4 or 5, wherein a depth of the indentation (124, 164) for accepting the pin (112) corresponds to a depth of the recess (114) of the pin (112).

7. Container (100) according to any of the preceding claims, wherein a cavity within the second one of the upper (110) and lower (120) components, in which the engagement member (122, 162) is supported, is accessible from the outside of the container (100).

8. Container (100) according to claim 7, wherein the cavity is sealingly covered by a removable cover (142).

9. Container (100) according to claim 8, wherein the cover (142) is transparent with respect to at least one portion of the wavelength spectrum comprising visible light and/or UV-light and/or X-ray-radiation.

10. Method (200) for storing and/or transporting a semiconductor fabrication article (190) comprising enclosing the article (190) in a container (100) according to any one of the preceding claims, and storing the container (100) within a storage position within a semiconductor fabrication stocker, particularly a reticle stocker.

11. Method (200) according to claim 10, further comprising receiving an EUV dual pod comprising an EUV inner pod and an EUV outer pod and containing the article (190), opening the outer pod and the inner pod, recovering the article (190) from the inner pod and arranging the container (100) around the article (190) retrieved from the inner pod.

12. Method (200) according to claim 10 or 11 comprising actuating (224) the engagement member (122, 162) into an unengaged position (D), opening (232) the container (100), placing the article (190) into the container, closing the container (100) and actuating (224) the engagement member (122, 162) into an engaged position (C).

13. Method (200) according to any one of claims 10 to 12, further comprising providing an EUV dual pod, wherein providing an EUV dual pod comprises
retrieving a container (100) according to any one of claims 1 to 10 from a respective storage position within the stocker,
actuating (224) the engagement member (122, 162) into the unengaged position (D) and
arranging an outer pod around the container (100).

14. Stocker for storing a semiconductor fabrication article (190), particularly one or more of a wafer, a chip, a substrate and a photolithography mask, particularly an EUV reticle, configured to perform a method (200) according to any one of claims 10 to 13 and to hold a number of containers (100) according to any one of claims 1 to 9 within storage positions in the stocker.
